Europäisches Patentamt

European Patent Office

Office européen des brevets

(19)

(11) Veröffentlichungsnummer: **0 487 950 A1**

## (12) EUROPÄISCHE PATENTANMELDUNG

(21) Anmeldenummer: **91118917.3**

(22) Anmeldetag: **06.11.91**

(51) Int. Cl.5: **H05K 1/00**

(30) Priorität: **29.11.90 DE 9016266 U**

(43) Veröffentlichungstag der Anmeldung:
**03.06.92 Patentblatt 92/23**

(84) Benannte Vertragsstaaten:
**AT BE CH DE FR GB IT LI NL**

(71) Anmelder: **Siemens Nixdorf
Informationssysteme Aktiengesellschaft
Fürstenallee 7
W-4790 Paderborn(DE)**

(72) Erfinder: **Wessely, Hermann, Dipl.-Ing.
Am Stadtpark 34 B
W-8000 München 60(DE)**

(74) Vertreter: **Fuchs, Franz-Josef, Dr.-Ing. et al
Postfach 22 13 17
W-8000 München 22(DE)**

(54) Mehrlagenleiterplatte in Mikroverdrahtungstechnologie.

(57) Die Erfindung bezieht sich auf eine Mehrlagenleiterplatte in Mikroverdrahtungstechnologie, bei der die Verbindungen der einzelnen Leiter in den unterschiedlichen Lagen mittels Sacklochdurchkontaktierungen (3) erfolgen, und die auf der Oberseite mit elektrischen Bauelementen (7) bestückbar ist, und der auf der Unterseite die Signal- und Potentialspannungen über Kontakte zuführbar sind. Andererseits zeigt sich aber, daß der Bedarf an Durchkontaktierung in der Nähe der bauteilebestückten Oberfläche der Mehrlagenleiterplatte weitaus größer ist, als etwa in der Nähe der Steckkontaktleiste. Die Erfindung sieht daher vor, daß die einzelnen Lagen der Mikroverdrahtung von der Bauelementeseite zur Kontaktseite eine fallende Zahl von Sacklochdurchkontaktierungen (3) aufweisen.

EP 0 487 950 A1

Die Erfindung betrifft eine Mehrlagenleiterplatte in Mikroverdrahtungstechnologie, bei der die Verbindungen der einzelnen Leiter in den unterschiedlichen Lagen mittels Sacklochdurchkontaktierungen erfolgen, und die auf der Oberseite mit elektrischen Bauelementen bestückbar ist und der auf der Unterseite die Signal- und Potentialspannungen über Kontakte zuführbar sind.

Für elektrisch und mechanisch hoch beanspruchte Leiterplatten, z.B. im Rechnerbau, wird für das Basismaterial von Leiterplatten im allgemeinen ein Epoxidharzglasfasergewebe verwendet. Sollen jedoch sehr viele Verbindungen auf möglichst kleinem Raum hergestellt werden, werden als Träger für elektrische Bauelemente auch Leiterplatten verwendet, die nach der sogenannten Mikroverdrahtungstechnologie hergestellt sind. Derartige Leiterplatten bestehen aus einem Komplex von Acrylharz und Polyamidlagen, die in einem besonderen Laminierungsprozeß hergestellt werden. Mehrere solche Leiterplatten sind zu einer Mehrlagenleiterplatte vereinigt, wobei die Verbindung der Leiter der einzelnen Lagen untereinander über Sacklochdurchkontaktierungen erfolgt. Zur Versteifung derartiger Mehrlagenleiterplatten können Glasfaserepoxidharzsubstrate verwendet werden, wie dies beispielsweise auf Seite 237 der Zeitschrift "Siemens Forschungs- und Entwicklungsberichte", Band 17, 1978, Nr. 5, beschrieben ist. Derartige Versteifungsplatten können auch als übliche Mehrlagenleiterplatten ausgebildet sein, wobei die einzelnen Lagen als Potentiallagen dienen können. Außerdem wurde bereits vorgeschlagen, einzelne Lagen der Versteifungsplatte auch als Signallage zu verwenden.

Bei dieser Art der Mikroverdrahtungsleiterplatten sind für die einzelnen Lagen Durchkontaktierungen vorgesehen, die in jeder Lage etwa eine gleiche Anzahl von Durchkontaktierungen aufweisen. Diese Durchkontaktierungen bedeuten jedoch einen erheblichen Fertigungsaufwand. Andererseits zeigt sich aber, daß der Bedarf an Durchkontaktierungen in der Nähe der bauteilebestückten Oberfläche der Mehrlagenleiterplatte weitaus größer ist, als etwa in der Nähe der Steckkontaktseite.

Aufgabe der vorliegenden Erfindung ist es daher, eine Mehrlagenleiterplatte in Mikroverdrahtungstechnologie zu schaffen, bei der bei gleichzeitiger Qualitätserhöhung eine Aufwandsverringerung bei der Herstellung der Leiterplatten erreicht wird.

Zur Lösung dieser Aufgabe sieht die Erfindung daher vor, daß die Mehrlagenleiterplatte derart ausgebildet ist, daß die einzelnen Lagen der Mikroverdrahtung von der Bauelementeseite zur Kontaktseite eine fallende Zahl von Sacklochdurchkontaktierungen aufweisen.

Durch diese Maßnahmen wird eine wesentlich kostengünstigere Fertigung von Mehrlagenleiterplatten in Mikroverdrahtungstechnologie erzielt.

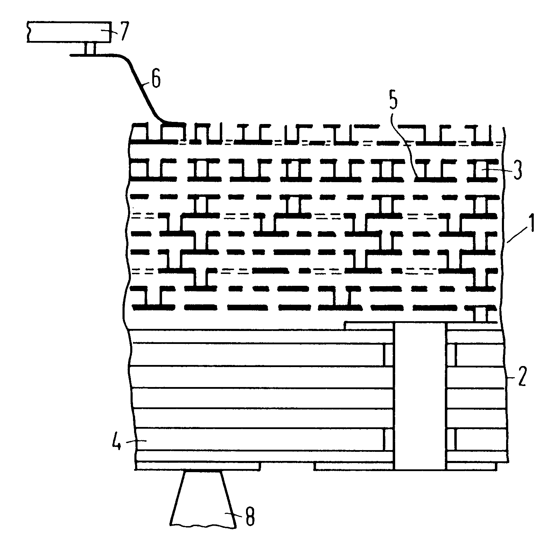

Anhand der Figur wird die Erfindung näher erläutert.

Die Figur zeigt im oberen Teil die Mikroverdrahtung 1 und im unteren Teil die in normaler Leiterplattentechnologie hergestellte Versteifungsplatte 2 mit unterschiedlichen Metallagen 4, die sowohl als Potential- als auch als Signallagen verwendet werden können. Die Mikroverdrahtung stellt die Verbindungen zu den einzelnen Lagen mit Hilfe von Sacklochdurchkontaktierungen 3 her, wobei der Boden des Sackloches mit der jeweiligen Metallschicht 5 der einzelnen Lage kontaktiert ist. Auf der Oberseite der Mikroverdrahtung 1 befinden sich die Bauelememte 7, die über die Kontaktbeinchen 6 an einem Kontaktbett der Oberfläche der Mikroverdrahtung 1 verlötet sind. An der Unterseite werden über Andrucksteckverbinder 8, der nur partiell angedeutet ist, die erforderlichen Potentiale und Signale zugeführt.

Die Sacklochdurchkontaktierungen 3 weisen in den unterschiedlichen Lagen der Mikroverdrahtung 1 eine unterschiedliche Anzahl auf, wobei die Durchkontaktierungen in ihrer Anzahl von der Bauelementenseite zur Steckerseite hin abnehmen.

**Patentansprüche**

1. Mehrlagenleiterplatte in Mikroverdrahtungstechnologie, bei der die Verbindungen der einzelnen Leiter in den unterschiedlichen Lagen mittels Sacklochdurchkontaktierungen erfolgen, und die auf der Oberseite mit elektrischen Bauelementen bestückbar ist und der auf der Unterseite die Signal- und Potentialspannungen über Kontakte zuführbar sind, **dadurch gekennzeichnet,** daß die einzelnen Lagen der Mikroverdrahtung von der Bauelementeseite zur Kontaktseite eine fallende Zahl von Sacklochdurchkontaktierungen aufweisen.

Europäisches
Patentamt

**EUROPÄISCHER RECHERCHENBERICHT**

Nummer der Anmeldung

EP    91 11 8917

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5 ) |
|---|---|---|---|
| A | EP-A-0 276 004 (MATSUSHITA ELECTRIC IND CO LTD)<br><br>----- | | H05K1/00 |
| | | | **RECHERCHIERTE SACHGEBIETE (Int. Cl.5 )**<br><br>H05K<br>H01L |

Der vorliegende Recherchenbericht wurde für alle Patentansprüche erstellt

| Recherchenort | Abschlußdatum der Recherche | Prüfer |
|---|---|---|
| DEN HAAG | 06 FEBRUAR 1992 | SCHUERMANS N. F. |